Europäisches Patentamt

European Patent Office

Office européen des brevets

(11) Numéro de publication: **0 107 993**
**A2**

(12) **DEMANDE DE BREVET EUROPEEN**

(21) Numéro de dépôt: **83401972.1**

(22) Date de dépôt: **10.10.83**

(51) Int. Cl.³: **H 01 L 41/22**

(30) Priorité: **22.10.82 FR 8217739**

(43) Date de publication de la demande:
**09.05.84 Bulletin 84/19**

(84) Etats contractants désignés:
**BE DE GB NL**

(71) Demandeur: **THOMSON-CSF**
**173, Boulevard Haussmann**
**F-75379 Paris Cedex 08(FR)**

(72) Inventeur: **Broussoux, Dominique**
**THOMSON-CSF SCPI 173, bld Haussmann**
**F-75379 Paris Cedex 08(FR)**

(72) Inventeur: **Facoetti, Hugues**
**THOMSON-CSF SCPI 173, bld Haussmann**
**F-75379 Paris Cedex 08(FR)**

(72) Inventeur: **Micheron, François**
**THOMSON-CSF SCPI 173, bld Haussmann**
**F-75379 Paris Cedex 08(FR)**

(72) Inventeur: **Monnerie, Lucien**
**THOMSON-CSF SCPI 173, bld Haussmann**
**F-75379 Paris Cedex 08(FR)**

(74) Mandataire: **Wang, Pierre et al,**
**THOMSON-CSF SCPI 173, Bld Haussmann**
**F-75379 Paris Cedex 08(FR)**

(54) Procédé de fabrication d'un matériau polymère piézo-ou pyroélectrique comportant une étape de réticulation.

(57) L'invention concerne les matériaux polymères piézo-électriques ou pyroélectriques.

L'invention a pour objet un procédé de fabrication de ces matériaux comportant la réticulation des chaînes constituant le polymère.

L'invention s'applique à des matériaux piézo- ou pyroélectriques susceptibles ou non d'être soumis à un recuit.

FIG.1

EP 0 107 993 A2

# PROCEDE DE FABRICATION D'UN MATERIAU POLYMERE PIEZO- OU PYROELECTRIQUE COMPORTANT UNE ETAPE DE RETICULATION

La présente invention se rapporte aux matériaux polymères piézoélectriques ou pyroélectriques. Elle concerne un procédé de fabrication comportant la réticulation des chaînes constituant le polymère qui a pour effet d'améliorer certaines de ses caractéristiques piézoélectriques et de lui conférer une meilleure stabilité dimensionnelle vis-à-vis des variations de température.

Certains polymères sont susceptibles d'acquérir des propriétés piézoélectriques ou pyroélectriques lorsqu'on les soumet à des contraintes mécaniques et électriques. C'est le cas notamment du polyfluorure de vinylidène (PVF$_2$) qui est l'un des plus employés. On confère à ce matériau des propriétés piézoélectriques par deux traitements successifs ou simultanés. Ces traitements consistent à faire subir à une feuille de PVF$_2$ un allongement d'un facteur égal au moins à trois, sous une température d'environ 70°C, et à la soumettre à un champ électrique intense supérieur ou égal à 1 MV/cm. Ces opérations peuvent être simultanées comme dans le cas du laminage sous polarisation. La déformation induite est en principe irréversible, sauf au voisinage de la température de fusion, car elle s'accompagne de la transition morphologique sphérolitique-fibrillaire. Toutefois, on constate qu'une partie de cette déformation est recouvrée par échauffement au-delà de la température de laminage : par exemple, un recuit à 90°C pendant 1 heure sans contraintes appliquées conduit à un retrait de 7 à 8 % dans la direction d'étirement et sensiblement la même augmentation relative d'épaisseur : volume et largeur (perpendiculairement au sens d'étirement) restent constants. Ce recuit assure à la feuille de polymère, pour des températures qui peuvent être plus élevées que celle correspondant aux opérations d'acquisition de ses propriétés piézo- ou pyroélectriques, la stabilité dimensionnelle dans le temps et un comportement stable de l'activité piézo- ou pyroélectrique. La stabilité de ces paramètres se fait cependant au détriment de l'activité piézoélectrique qui baisse de 10 à 30 %. D'autres inconvénients apparaissent également. Par exemple, les fréquences correspondant à des modes propres de vibration sont affectées, que l'échantillon soit libre (variations de dimensions) ou partiellement bloqué (variations de l'état de tension mécanique interne).

Afin de pallier cet inconvénient, l'invention propose de bloquer les mouvements possibles des chaînes macromoléculaires de la phase amorphe avant d'effectuer le recuit. En effet, l'examen en diffusion de rayons X aux petits angles montre que dans la succession périodique amorphe-cristallite le long des fibres du polymère, c'est la zone amorphe qui subit en quasi-totalité le retrait. Il est possible de bloquer les chaînes macromoléculaires de la zone amorphe par réticulation : la réticulation a pour objet d'établir des liens entre ces différentes chaînes et par conséquent d'accroître la rigidité du volume concerné.

L'invention a donc pour objet un procédé de fabrication d'au moins un élément piézoélectrique ou pyroélectrique à base de matériau polymère susceptible d'acquérir des propriétés piézoélectriques ou pyroélectriques, l'acquisition desdites propriétés comportant au moins une étape de polarisation électrique dudit matériau, caractérisé en ce qu'il comprend en outre une étape de réticulation des chaînes constituant ledit matériau polymère.

L'invention sera mieux comprise au moyen de la description ci-après et des figures annexées parmi lesquelles :

- la figure 1 est un diagramme représentant les pertes diélectriques en fonction de la température ;

- la figure 2 est un diagramme explicatif.

Il existe différentes méthodes de réticulation d'un matériau organique. On peut employer une méthode chimique : le couplage des chaînes peut se faire par exemple à l'aide de peroxydes. Une autre méthode possible de réticulation de chaînes organiques est l'irradiation à hautes énergies, par exemple par électrons. Cette dernière méthode est particulièrement intéressante du fait de sa facilité de mise en oeuvre. Afin de bien saisir le principe de l'invention, il est utile de rappeler les principales caractéristiques physiques des polymères piézoélectriques.

On décrira plus précisément le cas du $PVF_2$ qui est un exemple typique de polymère semi-cristallin, mais l'invention s'applique à tous les polymères piézoélectriques ou pyroélectriques. L'invention s'applique entre autres aux alliages et copolymèrs de $PVF_2$, au polychlorure de vinyle (PVC) ainsi qu'au polyfluorure de vinyle (PVF).

Le polymère $PVF_2$ à l'état fondu cristallise au refroidissement sous forme de sphérolithes dont le rayon varie de 0,1 micron à quelques microns (phase $\alpha$). Les sphérolithes sont formées de fibrilles contenant des lamelles dirigées radialement depuis le centre appelé centre de nucléation (d'épaisseur 100 à 200 angströms). Les lamelles sont formées de cristallites (ensembles de chaînes orientées et repliées) interconnectées par des parties amorphes. Des chaînes sans ordre lient les lamelles entre elles et les cristallites entre elles, formant ainsi la partie amorphe intercristalline. A ce stade, les propriétés mécaniques macroscopiques d'une feuille de $PVF_2$ sont celles d'un corps isotrope. La phase amorphe représente 40 à 60 % du matériau et correspond aux régions désordonnées interlamellaires et inter-sphérolithiques. A température ambiante, la phase amorphe étant visqueuse, elle détermine en grande partie les propriétés mécaniques du matériau.

Il existe par ailleurs une phase $\beta$ polaire qui présente le plus grand intérêt car elle se prête plus aisément au développement des propriétés piézoélectriques. On l'obtient principalement par transformation de phase mécanique à basse température (environ 70°C) à partir de la phase $\alpha$. La transformation mécanique consiste en un étirement de la feuille de polymère qui provoque une déformation irréversible. Les axes des cristallites (axes des chaînes macromoléculaires) tendent à s'orienter parallèlement à la direction d'étirement, donnant lieu à une morphologie de type fibrillaire. Les chaînes initialement en hélice prennent une configuration en zigzag permettant aux moments dipolaires électriques d'ajouter leurs effets. L'acquisition des propriétés piézoélectriques s'obtient alors en appliquant entre les deux faces de la feuille de $PVF_2$ étirée (3 à 4 fois sa valeur initiale) un champ électrique d'orientation de l'ordre de 1 MV/cm.

L'irradiation à haute énergie d'une feuille de polymère a deux effets principaux : rupture des chaînes principales ou latérales dont les bouts se recombinent selon un arrangement tridimensionnel alors qu'il était initialement de type unidimensionnel (chaînes alignées) et ionisations locales le long des chaînes qui créent des liaisons fortes entre elles. Aux faibles doses, la réticulation par électrons concerne essentiellement la phase amorphe et peu les zones cristallines. Ceci est dû au fait qu'il n'y a pratiquement pas d'ordre dans la phase amorphe tandis que de forts couplages entre chaînes existent dans les zones cristallines qui sont des zones ordonnées.

Le blocage, par réticulation, des mouvements des chaînes appartenant aux zones amorphes a donc pour conséquence d'augmenter la rigidité mécanique de l'échantillon concerné. Par voie de conséquence, lorsque l'on soumettra cet échantilon à un recuit stabilisateur, le retrait macroscopique subséquent au recuit sera diminué d'autant. La réticulation a aussi pour conséquence d'abaisser la constante diélectrique et les pertes des zones amorphes, et donc celles de l'échantillon dans son ensemble. En effet, les chaînes amorphes étant en partie bloquées, il en va de même pour les dipôles qu'elles portent : sous champ électrique appliqué, la polarisation d'orientation dipôlaire est limitée, ce qui se traduit par une diminution de permittivité diélectrique. De plus, la dimension moyenne des éléments de chaînes libres étant plus faibles qu'avant réticulation, le spectre des pertes diélectrique est nécessairement différent.

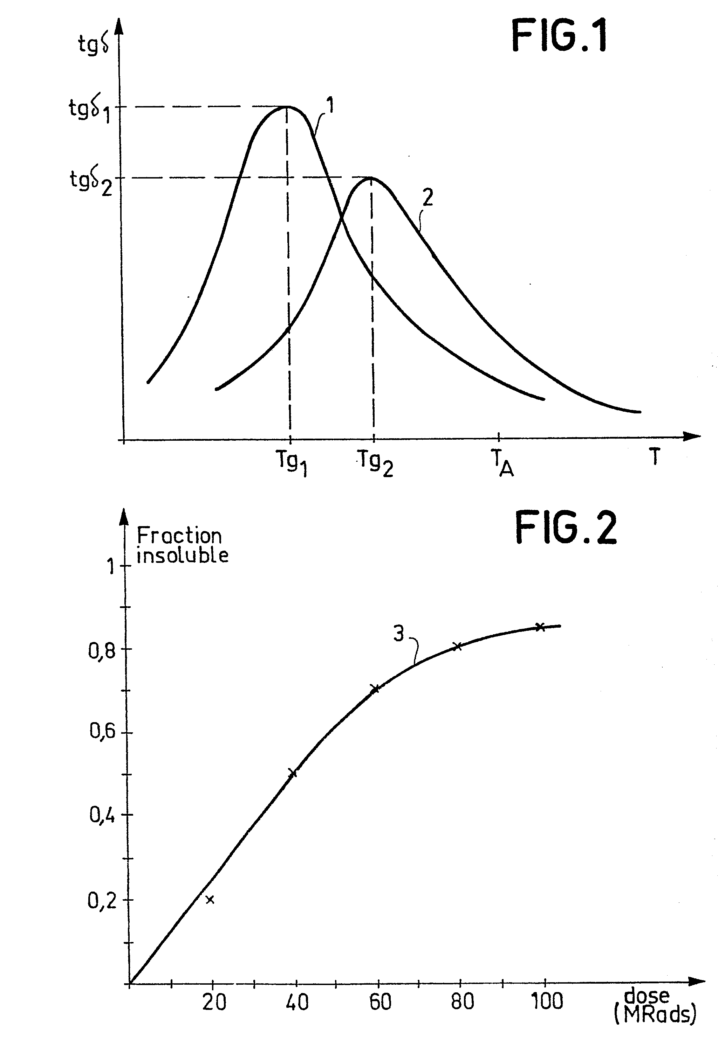

La figure 1 est un diagramme qui donne l'allure théorique des pertes diélectriques représentées par tg $\delta$ ( $\delta$ étant l'angle de pertes) en fonction de la température T, pour une feuille de $PVF_2$ à laquelle on a conféré des propriétés piézoélectriques. La courbe 1 est donnée pour une feuille de $PVF_2$ n'ayant pas subi de réticulation. La courbe 2, par contre, est donnée pour la même feuille ayant subi la réticulation par irradiations. Les courbes 1 et 2 ont une allure en forme de cloche et ont été tracées pour une fréquence donnée. Elles présentent respectivement des maxima pour les températures $Tg_1$ et $Tg_2$ appelées températures de transition vitreuse auxquelles correspondent des pertes tg $\delta_1$ et tg $\delta_2$. Pour chaque courbe, aux températures inférieures à la température de transition vitreuse, les zones amorphes du matériau correspondant sont rigides. Au-dessus de cette température, ces zones sont visqueuses ou fluides. A titre de comparaison, $T_A$ représente la température ambiante. On constate que si la température de transition vitreuse Tg croît lorsque l'on effectue la réticulation, par contre les pertes tg $\delta$ diminuent. Il y a également déplacement de la courbe tg $\delta$ = f(T) vers la droite du diagramme. Ce déplacement entraîne que, dans certaines zones de températures et à certaines fréquences, les pertes diélectriques sont réduites (mais augmentées dans d'autres). Cependant le maximum de pertes diminue lorsque le taux de réticulation augmente. La température Tg augmente avec la fréquence. Ceci conduit à optimiser les pertes en fonction de la gamme de fréquence et de la gamme de température qui correspondent à l'utilisation.

On peut prévoir que pour des doses d'irradiations telles qu'il y ait réticulation des zones amorphes et non destruction des zones cristallines, la polarisation rémanente soit peu affectée de même que les coefficients piézoélectriques $d_{ij} = \dfrac{dP_i}{dX_i}$. Dans ce cas, la réticulation de l'amorphe seul doit entraîner une augmentation des coefficients piézoélectriques $g_{ij} = \dfrac{d_{ij}}{\varepsilon_{33}}$ du fait que la permittivité $\varepsilon_{33}$ doit décroître plus vite que ne le fait $d_{ij}$. Il s'ensuit donc que la sensibilité en tension d'un capteur à piézoélectrique réticulé doit être augmentée. De même, on s'attend à ce que le coefficient de couplage électromécanique $K_{3i}^2 = \dfrac{d_{3i}^2 \cdot E_i}{\varepsilon_{33}} = g_{3i} \cdot d_{3i} \cdot E_i$ soit augmenté du fait de l'augmentation de $g_{3i}$ et du module d'Young $E_i$. Dans ce qui vient d'être dit on a considéré que la feuille de polymère est définie par un plan de direction 1 et 2, l'épaisseur de la feuille étant dans la direction 3 et l'étirement uniaxial ayant été réalisé dans la direction 1.

Les échantillons de $PVF_2$ peuvent être préparés de la façon suivante. Des granulés de $PVF_2$ sont tout d'abord pressés à 220° C pendant 10 minutes. La plaque obtenue est ensuite trempée dans l'eau puis on procède au laminage et à la polarisation simultanée à 75° C. Le taux d'étirement est d'environ 4 ce qui amène l'épaisseur finale à environ 170 microns. La tension de polarisation appliquée est de l'ordre de 15 kV. La feuille obtenue est alors chauffée à 80° C, légèrement tendue, pendant 30 minutes afin de la planéifier. La feuille de $PVF_2$ est maintenant prête à l'utilisation.

Afin de mettre en évidence l'influence de la réticulation sur le comportement piézoélectrique du $PVF_2$, on va comparer les résultats obtenus sur des échantillons identiques découpés dans la feuille précédemment élaborée. Les échantillons sont irradiés sous un accélérateur d'électrons à différentes doses de radiations. L'accroissement de dose est obtenu par irradiations successives. On dispose ainsi d'échantillons irradiés à 20, 40, 60, 80 et 100 MRads et d'un échantillon non irradié. Les six échantillons précédents sont alors soumis à un recuit à 90° C pendant 1 heure sans contraintes mécaniques appliquées. Après retour à la température ambiante, on mesure :

- la diminution de longueur $\Delta L$ parallèlement à la direction d'étirement due au retrait induit thermiquement ;

- l'accroissement d'épaisseur $\Delta e$ ;

- la diminution du coefficient piézoélectrique $\Delta d_{33}$.

Les résultats de ces mesures sont portés dans le tableau suivant sous forme de variations relatives de la longueur, de l'épaisseur et du coefficient piézoélectrique $d_{33}$ en fonction de la dose d'irradiation (de 0 à 100 MRads). Ils sont comparés à la fraction volumique du matériau qui est insoluble à 25° C dans un solvant tel que le dyméthyl formamide (DMF), ce qui constitue une mesure du taux de réticulation. En effet, ce sont les chaînes de la phase amorphe qui se dissolvent. Cette phase se dissout d'autant mieux que les liens entre les chaînes sont plus lâches.

| Dose (MRads) | 0 | 20 | 40 | 60 | 80 | 100 |
|---|---|---|---|---|---|---|
| Fraction insoluble | 0 | 0,2 | 0,5 | 0,7 | 0,8 | 0,85 |
| $-\dfrac{\Delta L}{L}$ (%) | 7 | 2,5 | 1,6 | 1,2 | 0,9 | 0,4 |
| $\dfrac{\Delta e}{e}$ (%) | 9,5 | 2,2 | 1,5 | 1,2 | 0,9 | 0,3 |
| $-\dfrac{\Delta d_{33}}{d_{33}}$ (%) | 13 | 6,5 | 3 | 2,4 | 2 | 1 |

A la lecture de ce tableau, on constate qu'un échantillon non irradié est complètement soluble. En effet, les cristallites n'ayant plus le support matériel de la phase amorphe, sont dispersés dans la solution. Lorsque la dose d'irradiations électroniques augmente, le taux de réticulation augmente également ce qui tend à rendre la masse amorphe entourant les cristallites plus rigide et moins soluble. La figure 2 est un diagramme qui représente la fraction volumique du matériau qui est insoluble en fonction de la dose

d'irradiations en MRads (courbe 3). De 0 à 60 Mrads d'irradiations la courbe 3 est pratiquement linéaire. Au-dessus de 60 Mrads, on constate que l'irradiation a moins d'effet sur la réticulation. Une dose de 100 MRads constitue pratiquement la saturation de la réticulation.

En revenant au tableau précédent, on remarque que la réticulation a un effet déterminant sur les variations relatives de la longueur L (dans la direction d'étirement), de l'épaisseur e des échantillons, du coefficient piézoélectrique $d_{33}$. Pour 100 MRads d'irradiations, ces variations relatives ont toutes été modifiées d'au moins un ordre de grandeur. L'essentiel de ces variations est obtenu pour une dose de 40 MRads, c'est-à-dire pour un taux de réticulation de 50 %. En effet, à ce niveau de réticulation, le recuit occasionne un retrait qui n'est que de 1,6 % au lieu de 7 % sans réticulation. De même $d_{33}$ ne diminue que de 3 % au lieu de 13 %.

La réticulation a également un effet sur les valeurs des coefficients piézoélectriques d'éléments polymères piézoélectriques n'ayant pas subi de recuit. Des mesures ont été effectuées sur de tels échantillons pour des fréquences inférieures ou égales à 1 kHz. En particulier, $\varepsilon_{33}$ et Tg ont été relevées pour 1 kHz. Le tableau qui suit regroupe l'ensemble des résultats de ces mesures. Comme dans le tableau précédent les doses d'irradiations électroniques s'échelonnent de 0 à 100 MRads. En fonction de la dose d'irradiations, on a relevé les coefficients piézoélectriques $d_{33}$ et $d_{31}$ la constante diélectrique $\varepsilon_{33}$, le module d'Young $E_1$, la température de transition vitreuse Tg et les pertes diélectriques maximales représentées par

tg $\delta_{max}$. De ces mesures on a déduit les coefficients $g_{33} = \dfrac{d_{33}}{\varepsilon_{33}}$ et

$g_{31} = \dfrac{d_{31}}{\varepsilon_{33}}$ ainsi que les coefficients de couplage électromécanique.

| Dose (MRads) | 0 | 20 | 40 | 60 | 80 | 100 |
|---|---|---|---|---|---|---|
| $d_{33}$ ($10^{-12}$ C.N$^{-1}$) | 24 | 23 | 23 | 23 | 23 | 22 |
| $d_{31}$ ($10^{-12}$ C.N.$^{-1}$) | 17 | 15,8 | 15,7 | 15,5 | 15,5 | 14,3 |
| $\varepsilon_{33}$ ($10^{-10}$ F/m) | 1,7 | 1,5 | 1,45 | 1,33 | 1,28 | 1,26 |
| $g_{33}$ ($10^{-2}$ V.m.N$^{-1}$) | 14,1 | 15,3 | 15,9 | 17,3 | 18 | 17,5 |
| $g_{31}$ ($10^{-2}$ V.m.N$^{-1}$) | 10 | 10,5 | 10,8 | 11,6 | 12,1 | 11,3 |
| $E_1$ ($10^9$ N.m$^{-2}$) | 3 | 3,8 | 3,6 | 3,9 | 4 | 4,1 |
| $k_{33}^2$ ($10^{-2}$) | 1 | 1,34 | 1,32 | 1,55 | 1,66 | 1,58 |
| $k_{31}^2$ ($10^{-2}$) | 0,51 | 0,63 | 0,61 | 0,7 | 0,75 | 0,66 |
| Tg (°C) | -21 | -16 | -11 | -8 | -5 | -3 |
| tg $\delta_{max}$ | 0,15 | 0,143 | 0,132 | 0,121 | 0,12 | 0,115 |

$$k_{33}^2 = \frac{d_{33}^2 \cdot E_3}{\varepsilon_{33}} \quad \text{et} \quad k_{31}^2 = \frac{d_{31}^2 \cdot E_1}{\varepsilon_{33}} \quad \text{en considérant que } E_3 \text{ est à peu}$$

près égal à $E_1$. L'examen de ce tableau montre que les coefficients $d_{33}$ et $d_{31}$ décroissent plus lentement que la constante diélectrique $\varepsilon_{33}$ avec l'irradiation excepté à la dose maximum de 100 MRads. Il s'ensuit que les coefficients $g_{33}$ et $g_{31}$ croissent continuellement jusqu'à la dose de 80 Mrads pour décroître ensuite. Le module d'Young $E_1$ croît avec l'irradiation avec une légère baisse autour de 40 MRads. On admettra que le module

$E_3$ a sensiblement la même valeur que $E_1$. Le sens des variations des paramètres $E_1$, $E_3$, $d_{33}$, $d_{31}$ et $\varepsilon_{33}$ entraîne pour $k_{33}^2$ et $k_{31}^2$ un accroissement jusqu'à une dose d'irradiations de 80 MRads avec une légère baisse autour de 40 MRads. Au-dessus de 80 MRads, $k_{33}^2$ et $k_{31}^2$ diminuent. La température de transition Tg, mesurée par la température du maximum des pertes diélectriques tg $\delta$ à 1 kHz croît régulièrement alors que décroissent les pertes diélectriques.

Des mesures ont été effectuées sur un transducteur à ultrason fonctionnant à la résonance en mode d'épaisseur à 5,5 MHz et conçu à partir d'une feuille de $PVF_2$ ayant subi un recuit. Sans irradiations les pertes diélectriques du transducteur représentent 27 %. Après irradiation à 40 MRads, les pertes diélectriques sont ramenées à 19 % et son atténuation propre entrée-sortie passe de 12,5 à 11 dB.

On pourrait donc conclure que l'optimum de dose d'irradiations est voisin de 80 MRads : c'est-à-dire pour les valeurs maximales de $g_{33}$, $g_{31}$, $k_{33}^2$ et $k_{31}^2$. Toutefois, on constate qu'au-delà de 50 MRads les échantillons deviennent cassants et tendent à se cliver spontanément sous forme de fibres parallèles à l'axe d'étirement. Ceci est dû au fait que les interconnexions entre les chaînes de la zone amorphe dues à la réticulation, se font surtout dans des plans parallèles. Etant donné que la plus grande partie du retrait est déjà obtenu pour la dose de 40 MRads et que les propriétés piézoélectriques sont améliorées à cette dose, l'optimum d'irradiations se situe donc au voisinage de cette dose, c'est-à-dire pour un taux de réticulation voisin de 0,5.

Il entre dans le cadre de l'invention d'appliquer la réticulation à d'autres polymères que le $PVF_2$, en particulier à ses alliages et copolymères, devant ou non subir un recuit. Ceci est réalisable que les températures de transition vitreuse soient supérieures ou inférieures à la température ambiante. Dans tous les cas, l'irradiation doit affecter le moins possible les cristallites. L'altération des cristallites semble se produire pour le $PVF_2$ au-delà de 80 MRads ce qui expliquerait la baisse des paramètres $\varepsilon_{33}$, $g_{33}$, $g_{31}$, $k_{33}^2$ et $k_{31}^2$ au-dessus de 80 MRads.

Il entre également dans le cadre de l'invention d'obtenir la réticulation des chaînes des zones amorphes par d'autres méthodes que l'irradiation électronique. On peut envisager une méthode chimique, par exemple à l'aide de peroxydes.

L'invention s'applique également aux polymères pyroélectriques. Elle s'applique également aux éléments piézoélectriques ou pyroélectriques qui n'ont pas eu besoin d'être soumis à un étirement ou à un effort physique quelconque pour obtenir une phase polaire. Comme il a été établi précédemment que la réticulation a aussi pour conséquence d'abaisser la constante diélectrique et les pertes des zones amorphes, on peut irradier ces éléments dans le seul but d'améliorer leurs propriétés piézoélectriques ou pyroélectriques.

La réticulation peut également ne pas concerner la totalité de la surface des éléments en question, notamment lorsque ces éléments comportent des zones plissées où une certaine souplesse est requise. De même on peut concevoir des ensembles comportant des éléments réticulés et d'autres qui ne le sont pas. Dans l'exemple choisi, on a préféré procéder à l'étape de réticulation après l'étape de polarisation mais il est possible d'inverser l'ordre de ces deux étapes.

Le procédé selon l'invention s'avère efficace pour combattre le retrait dû au recuit. Il améliore les propriétés piézoélectriques. De plus, son emploi est peu onéreux.

11

## REVENDICATIONS

1. Procédé de fabrication d'au moins un élément piézoélectrique ou pyroélectrique à base de matériau polymère susceptible d'acquérir des propriétés piézoélectriques ou pyroélectriques, l'acquisition desdites propriétés comportant au moins une étape de polarisation électrique dudit matériau, caractérisé en ce qu'il comprend en outre une étape de réticulation des chaînes constituant ledit matériau polymère.

2. Procédé de fabrication selon la revendication 1, caractérisé en ce que l'acquisition desdites propriétés comprend, avant ou pendant l'étape de polarisation électrique, une étape de traitement mécanique créant une anisotropie propice au développement desdites propriétés.

3. Procédé de fabrication selon la revendication 2, caractérisé en ce que ledit traitement mécanique consiste en l'étirement d'une feuille dudit matériau.

4. Procédé de fabrication selon l'une quelconque des revendications 1 à 3, caractérisé en ce que ladite étape de réticulation a lieu après ladite étape de polarisation électrique.

5. Procédé de fabrication selon l'une quelconque des revendications 2 ou 3, caractérisé en ce que ladite étape de réticulation a lieu après ladite étape de traitement mécanique et avant ladite étape de polarisation électrique.

6. Procédé de fabrication selon l'une quelconque des revendications 1 à 5, caractérisé en ce qu'il comprend une étape finale de recuit.

7. Procédé de fabrication selon l'une quelconque des revendications 1 à 6, caractérisé en ce que ledit matériau polymère est du polyfluorure de vinylidène.

8. Procédé de fabrication selon l'une quelconque des revendications 1 à 6, caractérisé en ce que ledit matériau polymère est un alliage à base de polyfluorure de vinylidène.

9. Procédé de fabrication selon l'une quelconque des revendications 1 à 6, caractérisé en ce que ledit matériau comprend des copolymères de polyfluorure de vinylidène.

12

10. Procédé de fabrication selon l'une quelconque des revendications 1 à 9, caractérisé en ce que ladite réticulation ne concerne qu'une partie dudit matériau polymère.

11. Procédé de fabrication selon l'une quelconque des revendications 1 à 10, caractérisé en ce que ladite réticulation est réalisée par irradiations d'électrons.

12. Procédé de fabrication selon l'une quelconque des revendications 1 à 11, caractérisé en ce que la réticulation est effectuée jusqu'à un taux égal à 0,5.

0107993

1/1

FIG.1

FIG.2